# EUROPEAN PATENT APPLICATION

(11) **EP 4 835 728 A1**
(43) Date of publication of application: **04.11.2026**
(21) Application number: 25186251.2
(22) Date of filing: 30.06.2025
(51) Int. Cl.: G06F 30/20

(54) **HIGH-PRECISION MULTI-SCATTERING WAVE PROPAGATION SOLVER AND ELECTROMAGNETIC FIELD RECONSTRUCTION METHOD USING THE SAME**

(30) Priority: 29.04.2025 KR 20250056055
(71) Applicant: Tomocube, Inc., Daejeon 34127 (KR); Korea Advanced Institute of Science and Technology, Daejeon 34141 (KR)
(72) Inventor: PARK, YongKeun, 34141 Daejeon (KR); HUGONNET, Herve Jerome, 34141 Daejeon (KR); OH, Chulmin, 34141 Daejeon (KR); PARK, Juyeon, 34141 Daejeon (KR)
(74) Representative: V.O.

(57) **Abstract**

The present disclosure relates to a high-precision multi-scattering wave propagation solver and an electromagnetic field reconstruction method using the same. According to the present disclosure, a computing device may be configured to detect scattering by each of a plurality of slices obtained by dividing a sample in an axial direction and to calculate multiple scattering in the sample, based on the scattering by the slices. Additionally, the computing device may update at least one parameter for the sample by an inverse algorithm for minimizing the difference between scattering measured with respect to the sample and the multiple scattering.

## Description

### Technical Field

The present disclosure relates to a high-precision multi-scattering wave propagation solver and an electromagnetic field reconstruction method using the same.

### Background Art

The technology of precisely analyzing scattering phenomena, which happens when various types of waves such as light, electron beams, X-rays, and ultrasonic waves pass through a medium, and performing an inverse or forward analysis based on the analysis of the scattering phenomena is essential in all areas of modern science and engineering. In optics, for example, light penetrating a material with a non-uniform refractive index is propagated in a complex manner, causing multiple scattering. Common methods designed to efficiently calculate these phenomena include finite-difference time-domain (FDTD), the beam propagation method (BPM), the Born approximation, the Rytov approximation, and multi-slice (MS) models.

However, the conventional techniques have their own strengths and limitations. The finite-difference time-domain is highly accurate because it solves electromagnetic Maxwell's equations directly, but, when applied to large-scale 3D simulations, its computational and memory demands increase sharply, making it unsuitable for real-time or large-scale simulations. Traditionally, the Born approximation and the Rytov approximation are based on single scattering, and therefore their accuracy drops in samples having a large refractive index contrast or in thick samples. Although the beam propagation method can simulate multiple scattering to some extent by using multi-slices, it has limitations in handling high-angle scattering or back-scattering since it is primarily based on paraxial approximation. Multi-slice models incorporate some ideas from the Born series and account for multiple scattering by propagating a wave through multiple slices in a stepwise manner. However, the multi-slice models still face challenges in adequately dealing with high-angle scattering and properly handling back-scattering.

With this background, there arises a need for a new solution for calculating the propagation of a wave passing through a complex and thick medium more accurately and faster. Recently, it is becoming increasingly necessary to precisely analyze multiple scattering effects, in particular, in bioimaging (e.g., cell/tissue images), semiconductor process measurement, nanooptical device design, ultrasonic CT (computed tomography), electron microscopy-based material analysis, etc. In 3D optical tomography, for example, simple linear approximation is hard to apply unless samples are thin. Thus, more accurate forward modeling and an inverse problem solver based on this modeling are essential.

### Disclosure of Invention

### Technical Problem

To meet these demands, the present disclosure proposes a "high-precision multi-scattering wave propagation solver" which accounts for multiple scattering even in high-angle regions and has a relatively lightweight computational structure. The high-precision multi-scattering wave propagation solver is a balanced method between finite-difference method-level full-wave modeling and multi-slice-based approaches, and is designed in a way that can be expanded to large-scale 3D analyses and be applied to physical systems for various types of waves, including sound waves, X-rays, and electron beams, as well as light. In this regard, it is expected that the high-precision multi-scattering wave propagation solver will be used in a wide range of areas, including 3D imaging of biological tissues, analysis of scattering characteristics of nanostructures, analysis of internal defects in semiconductor circuits, ultrasonic images, and optical metamaterial design.

The present disclosure provides a high-precision multi-scattering wave propagation solver and an electromagnetic field reconstruction method using the same.

### Solution to Problem

According to the present disclosure, there is provided a method of operating a computing device, the method including: detecting scattering by each of a plurality of slices obtained by dividing a sample in an axial direction; and calculating multiple scattering in the sample, based on the scattering by the slices.

According to the present disclosure, the method of operating a computing device may further include updating at least one parameter for the sample by an inverse algorithm for minimizing the difference between scattering measured with respect to the sample and the multiple scattering.

According to the present disclosure, there is provided a computing device including: a memory; and a processor connected to the memory and configured to execute at least one instruction stored in the memory, wherein the processor is configured to detect scattering by each of a plurality of slices obtained by dividing a sample in an axial direction and to calculate multiple scattering in the sample, based on the scattering by the slices.

According to the present disclosure, the processor may be configured to update at least one parameter for the sample by an inverse algorithm for minimizing the difference between scattering measured with respect to the sample and the multiple scattering.

According to the present disclosure, there is provided a non-transitory computer-readable recording medium storing a computer program for executing a multiple scattering analysis method on a computing device, the multiple scattering analysis method including: detecting scattering by each of a plurality of slices obtained by dividing a sample in an axial direction; and calculating multiple scattering in the sample, based on the scattering by the slices.

According to the present disclosure, the multiple scattering analysis method may further include updating at least one parameter for the sample by an inverse algorithm for minimizing the difference between scattering measured with respect to the sample and the multiple scattering.

### Advantageous Effects of Invention

According to the present disclosure, the following effects can be achieved.

First, accuracy can be improved. Since a technology of the present disclosure simulates scattering at much more various angles, including high angle and back-scattering regions, compared to the conventional linear approximations (e.g., the Born approximation, the Rytov approximation, etc.) or beam propagation method-based models, high accuracy can be achieved even for samples with a high refractive index difference or for thick structures. According to a simulation result, it was possible to reconstruct microstructures accurately or match scattering fields more physically and quantitively.

Second, computational efficiency and scalability. The amount of computation can be reduced several tens to several thousand times compared to the full 3D finite difference method. A technology of the present disclosure allows for efficient operation of GPU resources required for large-scale simulations using slicing and Fast Fourier Transform-based parallelization. Since computation time increases at a relatively slow rate even with growing simulation volume, the technology of the present disclosure is also applicable to industrial settings or large research projects (e.g., tomographic images of tissues, ultrasonic CT, semiconductor processes, etc.).

Third, incorporating an inverse problem solver provides applicability across diverse fields. The technology of the present disclosure is not limited to simple forward analysis but can three-dimensionally reconstruct physical, chemical, and structural properties of samples in conjunction with an inverse problem (optimization) solver. The technology of the present disclosure is applicable across a broad spectrum of wave imaging systems, including optical 3D imaging (e.g., cell/tissue holotomography), ultrasonic tomography, X-ray diffraction microscopy, and electron beam tomography.

Fourth, an open and scalable structure can be implemented. The technology of the present disclosure employs a modulated structure so as to account for additional physical effects such as polarization, complex refractive indices (including absorption), and non-linear optical media, which makes it easy for many researchers and engineers to customize at a high level. Since the physical reliability (e.g., energy conservation, error analysis, etc.) of simulation and reconstruction results can be quantitively evaluated, utilization in system calibration and quality management can be enhanced.

Fifth, industrial and academic values. Through the technology of the present disclosure, internal structures of thick biological tissues can be observed with high resolution, or immediate economic and academic performances can be expected from semiconductor nanopattern defect inspection or the like. The technology of the present disclosure is expected to contribute to fast prototyping and optimization in new optical devices (e.g., metalenses, phased-array devices, etc.) or ultrasonic and nanophotonics design processes.

### Brief Description of Drawings

FIG. 1 is a block diagram illustrating components of a computing device according to various embodiments.
FIG. 2 is a block diagram illustrating detailed components of the processor of FIG. 1.
FIG. 3 is a sequential chart illustrating a method of operating a computing device according to various embodiments.
FIG. 4 is a sequential chart illustrating in detail the step of calculating multiple scattering in the sample of FIG. 3.

### Disclosure of the Invention

The problems of the conventional techniques are summarized as follows:

First, multiple scattering analysis is complicated. When light (or wave) is scattered multiple times within a sample, the traditional single scattering approximations, i.e., the Born approximation and the Rytov approximation, show high error rates. Particularly, precisely reconstructing high-frequency regions is challenging when light passes through a material with a high refractive index difference or through a thick sample.

Second, handling high-angle scattering and back-scattering is challenging. Beam propagation methods and multi-slice models can handle multiple scattering in part, but they rely mostly on paraxial approximation and therefore not be able to properly simulate high-angle scattering or back-scattering in which light is deflected at large angles. Accordingly, analysis accuracy drops when the scattering intensity is high or the lighting angle is wide.

Third, the burden of large-scale computation. The finite difference methods (or finite element method (FEM), convergent Born series, E2E, etc.) known as the most refined propagation analysis have high accuracy, but memory usage and calculation time increase exponentially with sample volume. Thus, they are virtually impossible to apply in high-resolution and large-area 3D analysis, making them inapplicable to industrial settings beyond testing in laboratories.

Fourth, there are needs for diversification and fast calculation in applications. Both higher speeds and accuracy are required in bioimaging (e.g., tissue and cell analysis), semiconductor processes (e.g., circuit pattern and defect measurement), nanophotonics (e.g., metamaterial and lens design), ultrasonic CT, electron microscopy (e.g., analysis of internal structures of materials), and so on. As such, it is necessary to develop a solver that overcomes the problems of the conventional techniques and is universally applicable to various wave systems.

Accordingly, objectives of the present disclosure will be summarized as follows.

The first objective is to efficiently calculate multiple scattering. The present disclosure proposes a "scattering-layer-based method" in which a sample is divided into multiple thin slices (also referred to as sub-slabs) and a scattering phenomenon in each slice is efficiently calculated by Taylor expansion or a Born- or Rytov-based, sophisticated approach. Through this, multiple scattering which happens in samples with a high refractive index or in thick samples can be simulated more accurately.

The second objective is to model high-angle scattering and back-scattering. That is, the goal here is to overcome the problems with the existing multi-slice models which struggle with adequately dealing with high-angle scattering because they rely mostly on paraxial approximation. The present disclosure accounts for refraction and diffraction at high angles in a refined manner, by using position-based phase modulation in the spatial frequency domain (the 2D Fourier plane or the pupil plane) or performing Green's function-based partial convolution. Also, the present disclosure allows for utilizing information that is crucial in ultrasonic or X-ray diffraction, electron beam reflection, etc., by calculating back-scattering as well.

The third objective is to achieve a computational efficiency appropriate for large-scale 3D simulations. The present disclosure aims to provide a finite difference method-level accuracy and at the same time a multi-slice or beam propagation method-level, lightweight computational structure. That is, the goal here is to derive real-time or near real-time results even in large-scale 3D analyses, by effectively utilizing a Fast Fourier Transform (FFT) and dividing propagation and scattering into multiple steps for each slice so as to facilitate CPU (central processing unit) or GPU (graphic processing unit) parallelization.

The fourth objective is the applicability of a wide range of wave systems. The present disclosure is not limited to optical scalar waves but may be basically expanded to various systems having wave equations, including electron beams (e.g., electron microscopy), ultrasonic waves (e.g., acoustic wave propagation), X-rays (e.g., high energy photons), design of nanooptical structures (e.g., metamaterials), and so on. If the need arises, the wave systems may be customized to even include polarization, fully electromagnetic analysis (e.g., vector equations), etc.

All in all, it is a key objective of the present disclosure to propose a "general-purpose wave propagation solver that precisely accounts for multi-scattering propagation phenomena, even including high-angle scattering and back-scattering, and that has a high computational efficiency compared to the finite difference methods and is applicable to large-scale 3D simulations. Furthermore, the present disclosure provides a technical foundation, as an inverse solver utilizing this technology, that can be used in various fields such as optical 3D image reconstruction, ultrasonic CT, X-ray diffraction tomography, and electron beam tomography.

Hereinafter, specific details for the practice of the present disclosure will be described in detail with reference to the accompanying drawings. However, in the following description, detailed descriptions of well-known functions or configurations will be omitted when it may make the subject matter of the present disclosure rather unclear.

In the accompanying drawings, the same or corresponding elements are assigned the same reference numerals. In addition, in the following description of the embodiments, duplicate descriptions of the same or corresponding components may be omitted. However, even if descriptions of components are omitted, it is not intended that such components are not included in any embodiment.

Advantages and features of the disclosed embodiments and methods of accomplishing the same will be apparent by referring to embodiments described below in connection with the accompanying drawings. However, the present disclosure is not limited to the embodiments disclosed below, and may be implemented in various forms different from each other, and the present embodiments are merely provided to make the present disclosure complete, and to fully disclose the scope of the disclosure to those skilled in the art to which the present disclosure pertains.

The terms used herein will be briefly described prior to describing the disclosed embodiments in detail. The terms used herein have been selected as general terms which are widely used at present in consideration of the functions of the present disclosure, and this may be altered according to the intent of an operator skilled in the art, conventional practice, or introduction of new technology. In addition, in specific cases, certain terms may be arbitrarily selected by the applicant, and the meaning of the terms will be described in detail in a corresponding description of the embodiments. Therefore, the terms used in the present disclosure should be defined based on the meaning of the terms and the overall content of the present disclosure rather than a simple name of each of the terms.

As used herein, the singular forms "a," "an," and "the" are intended to include the plural forms as well, unless the context clearly indicates the singular forms. Further, the plural forms are intended to include the singular forms as well, unless the context clearly indicates the plural forms. Further, throughout the description, when a portion is stated as "comprising (including)" a component, it intends to mean that the portion may additionally comprise (or include) another component, rather than excluding the same, unless specified to the contrary.

Further, the term "module" or "unit" used herein refers to a software or hardware component, and "module" or "unit" performs certain roles. However, the meaning of the "module" or "unit" is not limited to software or hardware. The "module" or "unit" may be configured to be in an addressable storage medium or configured to reproduce one or more processors. Accordingly, as an example, the "module" or "unit" may include components such as software components, object-oriented software components, class components, and task components, and at least one of processes, functions, attributes, procedures, subroutines, program code segments, drivers, firmware, microcodes, circuits, data, database, data structures, tables, arrays, and variables. Furthermore, functions provided in the components and the "modules" or "units" may be combined into a smaller number of components and "modules" or "units", or further divided into additional components and "modules" or "units."

According to an embodiment, the "module" or "unit" may be implemented as a processor and a memory. The "processor" should be interpreted broadly to encompass a general-purpose processor, a central processing unit (CPU), a microprocessor, a digital signal processor (DSP), a controller, a microcontroller, a state machine, and so forth. Under some circumstances, the "processor" may refer to an application-specific integrated circuit (ASIC), a programmable logic device (PLD), a field-programmable gate array (FPGA), and so on. The "processor" may refer to a combination of processing devices, e.g., a combination of a DSP and a microprocessor, a combination of a plurality of microprocessors, a combination of one or more microprocessors in conjunction with a DSP core, or any other combination of such configurations. In addition, the "memory" should be interpreted broadly to encompass any electronic component that is capable of storing electronic information. The "memory" may refer to various types of processor-readable media such as random access memory (RAM), read-only memory (ROM), non-volatile random access memory (NVRAM), programmable read-only memory (PROM), erasable programmable read-only memory (EPROM), electrically erasable PROM (EEPROM), flash memory, magnetic or optical data storage, registers, and so on. The memory is said to be in electronic communication with a processor if the processor can read information from and/or write information to the memory. The memory integrated with the processor is in electronic communication with the processor.

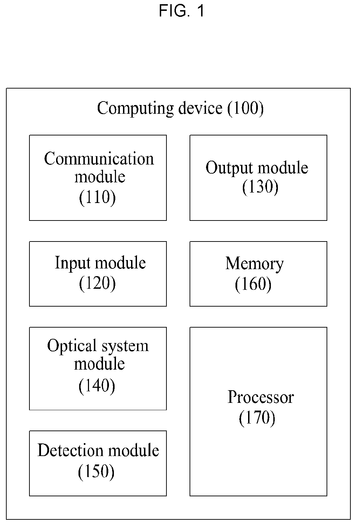

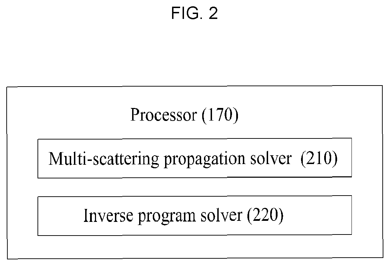

FIG. 1 is a block diagram illustrating components of a computing device 100 according to various embodiments. FIG. 2 is a block diagram illustrating detailed components of the processor 170 of FIG. 1.

Referring to FIG. 1, the computing device 100 may include at least one of a communication module 110, an input module 120, an output module 130, an optical system module 140, a detection module 150, a memory 160, or a processor 170. In some embodiments, at least one of the components of the computing device 100 may be omitted. In some embodiments, at least one other component may be added to the computing device 100. In some embodiments, at least two of the components of the computing device 100 may be implemented as one integrated circuit.

The communication module 110 in the computing device 100 may perform communication with external equipment. For example, the external equipment may include at least one of a device, a base station, a server, or a satellite. The communication module 110 may include at least one of a wired communication module or a wireless communication module. The wired communication module may be connected with wires to external equipment via a connecting terminal (not shown) and communicate with the external equipment in a wired manner. The wireless communication module may include at least one of a short-range communication module or a long-range communication module. The short-range communication module may communicate with the external equipment by a short-range communication method. The short-range communication method may include, for example, at least one of a cellular network, the internet, or a computer network such as LAN (local area network) or WAN (wide area network). In some embodiments, the communication module 130 may receive GNSS (global navigation satellite system) information. For example, the GNSS information may include GPS (global positioning system) information.

The input module 120 may feed signals that are to be used for at least one component of the computing device 100. In some embodiments, the input module 120 may include at least one of a microphone, a mouse, or a keyboard. In other embodiments, the input module 120 may include at least one of touch circuitry configured to sense touch or sensor circuitry configured to measure the intensity of a force generated by touch.

The output module 130 may output information from the computing device 100. The output module 130 may include at least one of a display module for visually showing information or an audio module for auditorily reproducing information. In one embodiment, the display module may include at least one of a display, a hologram device, or a projector. In other embodiments, the display module may be assembled with at least one of the touch circuitry or sensor circuitry of the input module 130 and implemented as a touchscreen. In some embodiments, the audio module may include at least one of a speaker, a receiver, an earphone, or a headphone.

The optical system module 140 in the computing device 100 may propagate a wave through a target so that the wave penetrates the target. Here, the wave may include at least one of light, an electron beam, an X-ray, or an ultrasonic wave. In some embodiments, the optical system module 140 may propagate a wave by using at least one of reflection or refraction. Specifically, the optical system module 140 may include at least one of a wave source, at least one reflective element, or at least one refractive element. The wave source may generate waves. In the case of light, for example, the wave source may include an LED (light emitting diode) array. The reflective element may reflect waves from the wave source. In the case of light, for example, the reflective element may include a digital micro-mirror device (DMD). The refractive element may refract waves from the wave source.

The detection module 150 in the computing device 100 may detect scattering with respect to the target. That is, as a wave penetrates the target, the detection module 150 may measure scattering emitted from the target. Here, the scattering is forward scattering, and may include at least one of the intensity, phase, or electromagnetic field of waves emitted from the target. For example, the detection module may include at least one of a beam scanner, an electron beam probe, an ultrasonic probe, an X-ray probe, an ultrasonic probe, a camera, a detector, or a sensor array.

The memory 160 may store various data used by at least one component of the computing device 100. For example, the memory 160 may include at least one of a volatile memory or a non-volatile memory. The data may include at least one program and input data or output data related thereto. The program may be stored in the memory 160 as software including at least one instruction.

The processor 170 may execute a program in the memory 160 to control at least one component of the computing device 100. Through this, the processor 170 may perform data processing or computation. Here, the processor 170 may execute an instruction stored in the memory 160.

In various embodiments, the processor 170 may calculate multiple scattering in a sample and reconstruct a microstructure of the sample by using multiple scattering. Here, the sample may be composed of a material with a uniform refractive index or a material with a non-uniform refractive index, that is, a material made up of a combination of regions with different refractive indices. For example, the sample may be a sample with a low refractive index, a sample with a high refractive index, a thin sample, or a thick sample. In some embodiments, the processor 170 may detect scattering by each of slices by performing parallel operations on the slices. To this end, the processor 170 may be implemented as a high-performance computing unit (e.g., GPU cluster, multicore CPU, etc.) and a software interface. Specifically, the processor 170 may include a multi-scattering propagation solver 210 and an inverse problem solver 220, as illustrated in FIG. 2.

The multi-scattering propagation solver 210 may calculate multiple scattering in the sample based on the scattering by each of a plurality of slices of the sample. Here, the slices may be obtained by dividing the sample in an axial direction. For example, the slices may have the same thickness. That is, the slices may form a sample by being arranged in parallel in another axial direction which is perpendicular to the axial direction, for example, in a thickness direction. In this way, the multi-scattering propagation solver 210 may define at least one parameter for the sample based on multiple scattering. Here, the parameter may include at least one of refractive index, acoustic impedance, or electronic density.

More specifically, the multi-scattering propagation solver 210 may propagate a wave through each slice by the optical system module 140 and detect scattering, i.e., forward scattering, by that slice by the detection module 150. In some embodiments, the multi-scattering propagation solver 210 may simulate scattering by each slice, by using at least one of the Born approximation, the Rytov approximation, Taylor expansion, or the pupil phase series (PPS).

Existing algorithms for the pupil phase series for propagation of waves through slices in a non-paraxial region require multiple steps and variables, and are often based on derivatives in axial fields. Here, these algorithms start from phase modulation of a field caused by variations in refractive index, which is expressed as a function of slice thickness and refractive index, though these phase changes are represented angle-dependently. These phase changes may be represented by a spatially variable convolution, as in the following [Equation 1], which may incur a high computational cost. The principle of the pupil phase series in this disclosure is to represent such a convolution by using the Taylor series, as in the following [Equation 2]. That is, the following [Equation 1] represents a spatially variable convolution, and the following [Equation 2] represents a Taylor series algorithm of the pupil phase series in the present disclosure. [Equation 1] $\begin{matrix}{Scat}_{PPS} \left({E}_{{z}_{k}}, {n}_{{z}_{k}}\right) = {∬}_{x , y} {E}_{{z}_{k}} \left(x, y\right) {P}_{PPS} \left({n}_{{z}_{k}}\left(x, y\right),x-x′,y-y′\right) dxdy \\ {P}_{PPS} \left({n}_{{z}_{k}}\left({x}_{2}, {y}_{2}\right),{k}_{xy}\right) = F \left\{{P}_{PPS}\left({n}_{{z}_{k}}\left({x}_{2}, {y}_{2}\right),x,y\right)\right\} = {e}^{{ik}_{0} \left({n}_{{z}_{k}}\left({x}_{2}, {y}_{2}\right)-{n}_{m}\right) δz \frac{{n}_{m} {k}_{0}}{{k}_{z}}}\end{matrix}$ [Equation 2] $\begin{matrix}{P}_{PPS} \left(m, {k}_{xy}\right) = {\sum }_{0 \leq q} \frac{{\left({ik}_{0}\left(m-{n}_{m}\right)δz\frac{{n}_{m} {k}_{0}}{{k}_{z}}\right)}^{q}}{q !} \\ {Scat}_{PPS} \left({E}_{{z}_{k}}, {n}_{{z}_{k}}\right) = {\sum }_{0 \leq q} \frac{1}{q !} {F}^{- 1} \left\{{\left(\frac{{n}_{m} {k}_{0}}{{k}_{z}}\right)}^{q}F\left\{{E}_{{z}_{k}}{\left({ik}_{0}\left({n}_{{z}_{k}}-{n}_{m}\right)δz\right)}^{q}\right\}\right\}\end{matrix}$

Moreover, the multi-scattering propagation solver 210 may calculate multiple scattering in the sample based on the scattering by the slices. In this instance, the multi-scattering propagation solver 210 may calculate the multiple scattering in the sample by a combination of the scattering by the slices, the propagation among the slices, and the high-angle scattering and the back-scattering. In some embodiments, the multi-scattering propagation solver 210 may derive the propagation among the slices by applying a Fast Fourier Transform-based propagation operation to the scattering by the slices. In some embodiments, the multi-scattering propagation solver 210 may derive both high-angle scattering and back-scattering in the sample with respect to the scattering by the slices, through spatial position-based phase modulation in the spatial frequency domain (2D Fourier plane or pupil plane) or through frequency domain convolution of Green's function. As such, the multi-scattering propagation solver 210 may define at least one parameter for the sample based on multiple scattering.

The inverse problem solver 220 may update at least one parameter for the sample by using multiple scattering. In some embodiments, the inverse problem solver 220 may iteratively update parameters. In some embodiments, the inverse problem solver 220 may update parameters with a small number of iterations and prevent overfitting, by incorporating an initialization method (e.g., linear approximate value) and regulation. As such, the inverse problem solver 220 may update multiple scattering according to the updated parameters.

More specifically, the inverse problem solver 220 may update parameters by an inverse algorithm for minimizing the difference between scattering measured with respect to the sample and multiple scattering, that is, multiple scattering calculated by using the slices. Here, the scattering measured with respect to the sample may involve detecting scattering in the sample by the detection module 150 by propagating a wave through the sample (i.e., the sample before slicing) by the optical system module 140. In some embodiments, the inverse algorithm may use at least one of various optimization techniques, including a quasi-Newton method, a direct integration method (Born series), OSEM (Order Subset Expectation Maximization), and ADMM (Alternating Direction Method of Multipliers). As such, the inverse problem solver 220 may update multiple scattering according to the updated parameters.

As a result, the processor 170 may reconstruct the microstructure of the sample by using multiple scattering in the sample. Additionally, the processor 170 may obtain a final value of at least one parameter for the sample.

In various embodiments, the computing device 100 is applicable to a wide range of wave systems, without limitation to an optical range. That is, in the technology of the present disclosure, the same principle may apply to propagation equations of various wavelengths such as electron beams (several pm to several nm), ultrasonic waves (several hundreds of kHz to several MHz), and X-rays (several pm to several nm), within a wavelength band ranging from several pm to several *µ*m. In some embodiments, the technology of the present disclosure may be designed in such a way that imaginary components, tensor forms, etc. are added to a scattering potential, in order to account for polarization, material absorption, non-linear media, and so on. In some embodiments, a computation engine of the processor 170 may be implemented to be optimized in a parallel computer environment such as a GPU cluster, a multicore CPU, etc. In some embodiments, the processor 170 may perform large-scale processing efficiently using high-performance hardware, by using a Fast Fourier transform or matrix-vector multiplication as a key element.

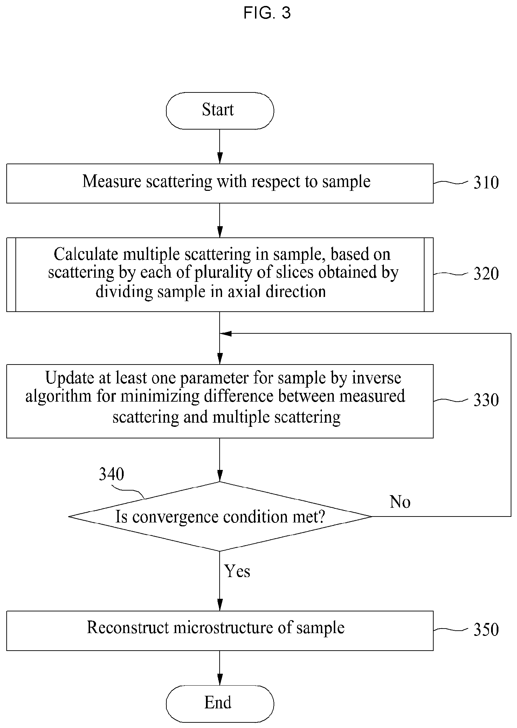

FIG. 3 is a sequential chart illustrating a method of operating a computing device 100 according to various embodiments.

Referring to FIG. 3, first, in the step 310, the computing device 100 may measure scattering with respect to a sample. Here, the sample may be composed of a material with a uniform refractive index or a material with a non-uniform refractive index, that is, a material made up of a combination of regions with different refractive indices. For example, the sample may be a sample with a low refractive index, a sample with a high refractive index, a thin sample, or a thick sample. Here, the wave may include at least one of light, an electron beam, an X-ray, or an ultrasonic wave. Meanwhile, the scattering is forward scattering, and may include at least one of the intensity, phase, or electromagnetic field of waves emitted from the sample. In one embodiment, the processor 170 may directly measure scattering with respect to the sample. A wave may be propagated through the sample by the optical system module 140, so that scattering in the sample may be detected by the detection module 150. The optical system module 140 may propagate a wave through the sample so that the wave penetrates the target. In some embodiments, the optical system module 140 may propagate a wave by using at least one of reflection or refraction. The detection module 150 may measure scattering emitted from the sample as a wave penetrates the sample. In other embodiments, an external device may measure scattering with respect to the sample, and the processor 170 may receive the measured scattering from the external device through the communication module 110 or the input module 120.

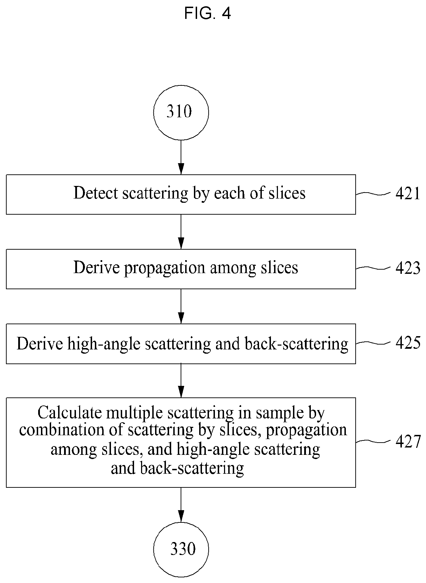

Subsequently, in the step S320, the computing device 100 may calculate multiple scattering in the sample, based on scattering by each of a plurality of slices of the sample. Here, the slices may be obtained by dividing the sample in an axial direction. For example, the slices may have the same thickness. That is, the slices may form a sample by being arranged in parallel in another axial direction which is perpendicular to the axial direction, for example, in a thickness direction. Here, the scattering by each slice is forward scattering, and may include at least one of the intensity, phase, or electromagnetic field of waves emitted from the slice. Meanwhile, multiple scattering in the sample includes at least one of forward scattering, high-angle scattering, or back-scattering, and may be simulated to include at least one of the intensity, phase, or electromagnetic field of waves emitted from the sample. This will be described in more details with reference to FIG. 4.

FIG. 4 is a sequential chart showing in detail the step 320 of calculating multiple scattering in the sample of FIG. 3.

Referring to FIG. 4, in the step 421, the computing device 100 may detect scattering by each of slices. More specifically, the processor 170 may propagate a wave through each slice by the optical system module 140 and detect scattering by the slice by the detection module 150. The detection module 150 may measure scattering emitted from the slice as a wave penetrates each slice. In some embodiments, the processor 170 may simulate scattering by each slice, by using at least one of the Born approximation, the Rytov approximation, Taylor expansion, or the pupil phase series (PPS). As such, the computation of each of the slices is decomposed into a combination of 2D fast Fourier transform operations. In some embodiments, the processor 170 may detect scattering by each of the slices by performing operations on the slices in a parallel manner.

Next, in the step 423, the computing device 100 may derive the propagation among the slices. In some embodiments, the processor 170 may derive the propagation among the slices by applying a Fast Fourier transform-based propagation operation to the scattering by the slices. For example, the processor 170 may apply a Fast Fourier transform-based propagation operation (e.g., k-space propagation) according to a scalar wave equation or a vector equation (when polarization is considered).

Next, in the step 425, the computing device 100 may derive high-angle scattering and back-scattering in the sample. In some embodiments, the processor 170 may derive high-angle scattering and back-scattering in the sample with respect to the scattering by the slices, through spatial position-based phase modulation in the spatial frequency domain (pupil plane) or through frequency domain convolution of Green's function.

Next, in the step 427, the computing device 100 may calculate multiple scattering in the sample. Specifically, the processor 170 may calculate the multiple scattering in the sample by a combination of the scattering by the slices, the propagation among the slices, and the high-angle scattering and the back-scattering. As such, the processor 170 may define at least one parameter for the sample based on multiple scattering. Here, the parameter may include at least one of refractive index, acoustic impedance, or electronic density.

Subsequently, referring back to FIG. 3, in the step 330, the computing device 100 may update at least one parameter for the sample by using multiple scattering. Here, the parameter may include at least one of refractive index, acoustic impedance, or electronic density. Specifically, the processor 170 may update parameters by an inverse algorithm for minimizing the difference between scattering measured with respect to the sample and the multiple scattering, that is, the multiple scattering calculated by using the slices. The processor 170 may update parameters by calculating a gradient from the difference between the measured scattering and the multiple scattering and optimizing, i.e., minimizing, the gradient through an inverse algorithm. In some embodiments, the inverse algorithm may use at least one of various optimization techniques, including a quasi-Newton method, a direct integration method (Born series), OSEM, and ADMM. Here, the difference may represent an error. As such, the processor 170 may update multiple scattering according to the updated parameters.

Then, in the step 340, the computing device 100 may determine whether a convergence condition is met. Here, the convergence condition may represent that the difference between the scattering measured with respect to the sample and the multiple scattering, i.e., the updated multiple scattering, is within a predetermined threshold range. More specifically, the processor 170 may determine whether a convergence condition is met, by comparing the difference with a threshold range. If the difference is within the threshold range, the processor 170 may determine that the convergence condition is met. On the other hand, if the difference is out of the threshold range, the processor 170 may determine that the convergence condition is not met. If the convergence condition is not met, the processor 170 may return to the step 330 and repeat the step 330 and the step 340. In this case, in the step 330, the processor 170 may additionally update at least one parameter for the sample. Specifically, the processor 170 may update parameters by minimizing the difference between the scattering measured with respect to the sample and the multiple scattering, i.e., the updated multiple scattering, by the inverse algorithm. As such, the processor 170 may additionally update multiple scattering according to the updated parameters. In one embodiment, the processor 170 may enable fast convergence with a small number of iterations and prevent overfitting, by incorporating an initialization method (e.g., linear approximate value) and regulation.

Lastly, in the step 350, the computing device 100 may reconstruct the microstructure of the sample. The processor 170 may reconstruct the microstructure of the sample by using multiple scattering in the sample. That is, once a convergence condition is met in the step 340, the processor 170 may calculate the microstructure of the sample by using final multiple scattering. Additionally, the processor 170 may obtain a final value of at least one parameter for the sample.

In one embodiment, the computing device 100 may calculate multiple scattering in the sample corresponding to each of different wave propagation angles and therefore reconstruct the microstructure of the sample by a combination of the multiple scattering. Specifically, in the step 310, the processor 170 may measure scattering corresponding to each of different wave propagation angles with respect to the sample. As such, multiple projection data may be acquired. Next, in the step 320, the processor 170 may detect scattering by the slices corresponding to each of different wave propagation angles and, based on this, calculate multiple scattering in the sample. In this manner, the processor 170 may calculate multiple scattering in the sample corresponding to each of different wave propagation angles. As a result, the processor 170 may reconstruct the microstructure of the sample by a combination of the multiple scattering at different wave propagation angles.

In other embodiments, the computing device 100 may calculate multiple scattering in the sample corresponding to each of different wave propagation angles and therefore reconstruct the microstructure of the sample by a combination of the multiple scattering. That is, the processor 170 may reconstruct the microstructure of the sample by a combination of the multiple scattering in the sample corresponding to at least two of light, electron beams, X-rays, or ultrasonic waves. Specifically, in the step 310, the processor 170 may measure scattering corresponding to each of different types of waves with respect to the sample. As such, multiple illumination data may be acquired. Next, in the step 320, the processor 170 may detect scattering by the slices corresponding to each of different types of waves and, based on this, calculate multiple scattering in the sample. In this manner, the processor 170 may calculate multiple scattering in the sample corresponding to each of different types of waves. As a result, the processor 170 may reconstruct the microstructure of the sample by a combination of the multiple scattering of different types of waves.

In various embodiments, the computing device 100 is applicable to a wide range of wave systems, without an optical range limitation. That is, in the technology of the present disclosure, the same principle may apply to propagation equations for various wavelengths such as electron beams (several pm to several nm), ultrasonic waves (several hundreds of kHz to several MHz), and X-rays (several pm to several nm), within a wavelength band ranging from several pm to several *µ*m. In some embodiments, the technology of the present disclosure may be designed in such a way that imaginary components, tensor forms, etc. are added to a scattering potential, in order to account for polarization, material absorption, non-linear media, and so on. In some embodiments, a computation engine of the processor 170 may be implemented to be optimized in a parallel computer environment such as a GPU cluster, a multicore CPU, etc. In some embodiments, the processor 170 may perform large-scale processing efficiently using high-performance hardware, by using a Fast Fourier transform or matrix-vector multiplication as a key element.

Therefore, the technology of the present disclosure may have the following features.

First, the accuracy of high-angle scattering and back-scattering can be improved. The technology of the present disclosure may accurately calculate high-angle scattering and back-scattering through phase correction for each position in the spatial frequency domain (pupil plane) or Green function-based convolution, compared to the existing multi-slice or beam propagation method. This advantage is more crucial when the sample has a large refractive index difference or when using a light with a broad-angle spectrum (high numerical aperture (NA)).

Second, computational efficiency can be attained through Taylor expansion and Fast Fourier Transform. The technology of the present disclosure may decompose a computation into a combination of 2D Fast Fourier Transform operations by applying Taylor expansion (the Born series expansion) slice by slice, while aiming toward an accuracy comparable to that of the full finite difference method analysis. As such, the thinner the slices, the smaller the amount of phase modulation within each slice (week sub-layer) and hence the higher the accuracy, and the computation becomes parallelized and therefore becomes significantly faster.

Third, the technology of the disclosure is easy to incorporate with a fast inverse algorithm. The technology of the present disclosure may utilize a complex multiple scattering model within a computation time comparable to that of a multi-slice-based propagation solver, when solving an inverse problem. By incorporating an initialization method (e.g., linear approximate value) and regulation, fast convergence is enabled with a small number of iterations, and overfitting can be prevented.

Fourth, applicability across a wide range can be achieved. The technology of the present disclosure can be utilized in various areas including ultrasonic wave-based medical imaging (e.g., heart, brain tissue, etc.), electron microscopy-based nanomaterial analysis, and X-ray diffraction tomography, as well as optical microscopy (e.g., 3D holography, optical diffraction tomography, digital forensics, etc.). The technology of the present disclosure may act as a fast design/simulation platform in designing metamaterials/metasurfaces, optimizing optical devices (e.g., optical computing, photonic devices), acoustic metamaterials, laser machining, and so on.

Tests were carried out in order to assess the performance of the technology of the present disclosure.

The first test was an artificial scatterer simulation test. In this test, reference data (truth values) were obtained by analyzing a spherical scatterer with a high refractive index (e.g., n=1.50) by a finite difference method, and they were compared with analysis results obtained by the technology of the present disclosure, the Born approximation, the Rytov approximation, and the beam propagation method. The comparison results showed that the Born approximation and the Rytov approximation were only effective for single scattering and large errors occurred at the center or in high-angle regions. The beam propagation method also experienced energy loss and large errors in high-angle scattering. On the other hand, the technology of the present disclosure reconstructed similar results to those obtained using the finite difference method within a short computation time.

The second test was a 3D sample reconstruction test using optical microscopy. In this test, an LED array-based optical microscope and a lens with a high numerical aperture (0.8 or higher) were used, and different wave propagation angles were applied to biological cells (several tens of *µ*m thick). In this test, the technology of the present disclosure reconstructed 3D refractive indices for biological cells by using the multi-scattering propagation solver 210 and the inverse problem solver 220 and compared them with analysis results obtained by the Born approximation and the Rytov approximation. The comparison results showed that, while the Born approximation and the Rytov approximation failed to reconstruct regions deep inside the biological cells or reconstruct minute organs with a high refractive index, the technology of the present disclosure succeeded in reconstructing the biological cells with high accuracy, even for high-angle scattering and back-scattering. The technology of the present disclosure reconstructed biological cells within a short time at a speed several tens to several hundreds of times faster than the finite difference method.

The third test was a test of application to ultrasonic CT or X-ray diffraction data. In this test, ultrasonic waves and X-rays were applied to a thick sample (e.g., bone tissue, metal composites, etc.). In this test, according to the technology of the present disclosure, a constant (e.g., density, absorption coefficient, etc.) required for acoustic/high-energy photon analyses, not optical ones, was incorporated, and then the sample was reconstructed by using the multi-scattering propagation solver 210 and the inverse problem solver 220. The results demonstrated that an accurate internal structure and physical property map of the sample had been reconstructed even in regions where distortion caused by multiple scattering was large. That is, the resolution and quantitativeness were improved compared to traditional tomographic imaging methods.

Based on such performance, the technology of the present disclosure allows for a variety of additional applications. A first example of them is multiple scattering analysis in electron microscopy (scanning TEM). The technology of the present disclosure allows for efficient calculation of multiple scattering that occurs in a process in which an electron beam passes through and is diffracted by a nanocrystal. A second example is the design of metamaterials and nanooptical devices. By optimizing a structure having desired transmission, reflection, and phase distributions by inverse problem design, the technology of the present disclosure can achieve fast convergence and high accuracy. A third example is a semiconductor process. The technology of the present disclosure can be utilized to analyze scattering between a photomask and a wafer in EUV (extreme ultraviolet) lithography and to correct measurement errors caused by multiple scattering of light in measurement equipment.

To sum up, the present disclosure includes a computing device 100 for multiple scattering analysis and a method of operating the same.

According to various embodiments, the method of operating the computing device 100 may include the steps (step 320 and step 421) of detecting scattering by each of a plurality of slices obtained by dividing a sample in an axial direction, and the step (step 320) of calculating multiple scattering in the sample based on the scattering by the slices.

According to various embodiments, the step (step 320 and step 421) of calculating scattering by the slices may include the step of simulating the scattering by each of the slices by using at least one of the Born approximation, the Rytov approximation, Taylor expansion, or the pupil phase series (PPS).

According to various embodiments, the step (step 320) of calculating multiple scattering in the sample may include the step (step 423) of deriving the propagation among the slices by applying a Fast Fourier Transform-based propagation operation to the scattering by the slices, the step (step 425) of deriving high-angle scattering and back-scattering in the sample with respect to the scattering by the slices, through spatial position-based phase modulation in the spatial frequency domain or through frequency domain convolution of Green's function, and the step (step 427) of calculating the multiple scattering in the sample by a combination of the scattering by the slices, the propagation among the slices, and the high-angle scattering and the back-scattering.

According to various embodiments, the method of operating the computing device 100 may further include the step (step 330) of updating at least one parameter for the sample by an inverse algorithm for minimizing the difference between scattering measured with respect to the sample and the multiple scattering.

According to various embodiments, the computing device 100 includes a memory 160 and a processor 170 connected to the memory 160 and configured to execute at least one instruction stored in the memory 160, and the processor 170 may be configured to detect scattering by each of a plurality of slices obtained by dividing the sample in an axial direction and calculating multiple scattering in the sample based on the scattering by the slices.

According to various embodiments, the processor 170 may be configured to simulate the scattering by each of the slices by using at least one of the Born approximation, the Rytov approximation, Taylor expansion, or the pupil phase series.

According to various embodiments, the processor 170 may be configured to derive the propagation among the slices by applying a Fast Fourier Transform-based propagation operation to the scattering by the slices, derive high-angle scattering and back-scattering in the sample with respect to the scattering by the slices, through spatial position-based phase modulation in the spatial frequency domain or through frequency domain convolution of Green's function, and to calculate the multiple scattering in the sample by a combination of the scattering by the slices, the propagation among the slices, and the high-angle scattering and the back-scattering.

According to various embodiments, the processor 170 may update at least one parameter for the sample by an inverse algorithm for minimizing the difference between scattering measured with respect to the sample and the multiple scattering.

The above-described method may be provided as a computer program stored on a computer-readable recording medium for execution on a computer. The medium may be a computer-executable program that is continuously stored or temporarily stored for execution or download. In addition, the medium may be various recording means or storage means in the form of a single or multiple hardware combinations, and is not limited to a medium directly connected to a computer system, and may be distributed on a network. Examples of the medium may include magnetic media such as hard disks, floppy disks, and magnetic tapes, optical recording media such as CD-ROMs and DVDs, magneto-optical media such as floptical disks, and ROMs, RAMs, flash memories, etc., configured to store program instructions. In addition, examples of other media may include recording media or storage media managed by app stores that distribute applications or other sites, servers, etc. that supply or distribute various software.

The methods, operations, or techniques of the present disclosure may be implemented by various means. For example, these techniques may be implemented in hardware, firmware, software, or a combination thereof. Those skilled in the art will appreciate that the various exemplary logical blocks, modules, circuits, and algorithm steps described in connection with the present disclosure may be implemented as electronic hardware, computer software, or combinations of both. To clearly illustrate this interchangeability of hardware and software, various exemplary components, blocks, modules, circuits, and steps have been described above generally in terms of their functionality. Whether such functionality is implemented as hardware or software will depend upon the particular application and design requirements imposed on the overall system. Those skilled in the art may implement the described functionality in various ways for each particular application, but such implementations should not be construed as causing a departure from the scope of the present disclosure.

In a hardware implementation, the processing units utilized to perform the techniques may be implemented within one or more ASICs, DSPs, digital signal processing devices (DSPDs), programmable logic devices (PLDs), field programmable gate arrays (FPGAs), processors, controllers, microcontrollers, microprocessors, electronic devices, other electronic units designed to perform the functions described herein, a computer, or a combination thereof.

Accordingly, the various illustrative logical blocks, modules, and circuits described in connection with the present disclosure may be implemented or performed by any combination of a general-purpose processor, a DSP, an ASIC, an FPGA or other programmable logic device, discrete gate or transistor logic, discrete hardware components, or those designed to perform the functions described herein. A general-purpose processor may be a microprocessor, but in the alternative, the processor may be any conventional processor, controller, microcontroller, or state machine. The processor may also be implemented as a combination of computing devices, e.g., a combination of a DSP and a microprocessor, a plurality of microprocessors, one or more microprocessors in conjunction with a DSP core, or any other such configuration.

In firmware and/or software implementation, the techniques may be implemented as instructions stored in a computer-readable medium such as random access memory (RAM), read-only memory (ROM), non-volatile random access memory (NVRAM), programmable read-only memory (PROM), erasable programmable read-only memory (EPROM), electrically erasable PROM (EEPROM), flash memory, compact disc (CD), or magnetic or optical data storage device. The instructions may be executable by one or more processors, and may cause the processor(s) to perform certain aspects of the functionality described in the present disclosure.

Although the above-described embodiments have been described as utilizing aspects of the subject matter disclosed herein on one or more standalone computer systems, the disclosure is not limited thereto and may also be implemented in conjunction with any computing environment such as a network or distributed computing environment. Furthermore, aspects of the subject matter of this disclosure may be implemented with multiple processing chips or devices, and storage may be similarly effected across the multiple devices. These devices may include PCs, network servers, and portable devices.

Although the present disclosure has been described in relation to some embodiments in this specification, various modifications and changes may be made without departing from the scope of the present disclosure as can be understood by those skilled in the art to which the invention pertains. In addition, such modifications and changes should be considered to fall within the scope of the claims attached herein.

## Claims

1. A method of operating a computing device, the method comprising:
detecting scattering by each of a plurality of slices obtained by dividing a sample in an axial direction; and
calculating multiple scattering in the sample, based on the scattering by the slices.

2. The method of claim 1, wherein the calculating of the scattering by each of the slices includes simulating the scattering by each of the slices by using at least one of the Born approximation, the Rytov approximation, Taylor expansion, or the pupil phase series.

3. The method of claim 1, wherein the calculating of the multiple scattering in the sample includes:
deriving the propagation among the slices by applying a Fast Fourier Transform-based propagation operation to the scattering by the slices;
deriving high-angle scattering and back-scattering in the sample with respect to the scattering by the slices, through spatial position-based phase modulation in the spatial frequency domain or through frequency domain convolution of Green's function; and
calculating the multiple scattering in the sample by a combination of the scattering by the slices, the propagation among the slices, and the high-angle scattering and the back-scattering.

4. The method of claim 1, further comprising updating at least one parameter for the sample by an inverse algorithm for minimizing the difference between scattering measured with respect to the sample and the multiple scattering.

5. A computing device comprising:
a memory; and
a processor connected to the memory and configured to execute at least one instruction stored in the memory,
wherein the processor is configured to detect scattering by each of a plurality of slices obtained by dividing a sample in an axial direction and to calculate multiple scattering in the sample, based on the scattering by the slices.

6. The computing device of claim 5, wherein the processor is configured to simulate the scattering by each of the slices by using at least one of the Born approximation, the Rytov approximation, Taylor expansion, or the pupil phase series.

7. The computing device of claim 5, wherein the processor is configured to derive the propagation among the slices by applying a Fast Fourier Transform-based propagation operation to the scattering by the slices, to derive high-angle scattering and back-scattering in the sample with respect to the scattering by the slices, through spatial position-based phase modulation in the spatial frequency domain or through frequency domain convolution of Green's function, and to calculate the multiple scattering in the sample by a combination of the scattering by the slices, the propagation among the slices, and the high-angle scattering and the back-scattering.

8. The computing device of claim 5, wherein the processor is configured to update at least one parameter for the sample by an inverse algorithm for minimizing the difference between scattering measured with respect to the sample and the multiple scattering.

9. A non-transitory computer-readable recording medium storing a computer program for executing a multiple scattering analysis method on a computing device,
the multiple scattering analysis method comprising:
detecting scattering by each of a plurality of slices obtained by dividing a sample in an axial direction; and
calculating multiple scattering in the sample, based on the scattering by the slices.

10. The recording medium of claim 9, wherein the multiple scattering analysis method further comprises updating at least one parameter for the sample by an inverse algorithm for minimizing the difference between scattering measured with respect to the sample and the multiple scattering.

## Amended claims

### Amended claims in accordance with Rule 137(2) EPC.

1. A method of operating a computing device (100), the method comprising:
detecting scattering by each of a plurality of slices (21) obtained by dividing a sample (20) in an axial direction; and
calculating multiple scattering in the sample, based on the scattering by the slices, wherein detecting scattering by each of the slices (21) comprises representing a spatially variable convolution associated with each slice by a Taylor expansion, wherein the multiple scattering is calculated by combining the scattering by the slices (21), and wherein the calculated multiple scattering is used to reconstruct a microstructure of the sample (20).

2. The method of claim 1, wherein the calculating of the scattering by each of the slices (21) includes simulating the scattering by each of the slices by using at least one of the Born approximation, the Rytov approximation, Taylor expansion, or the pupil phase series.

3. The method of claim 1, wherein the calculating of the multiple scattering in the sample includes:
deriving the propagation among the slices by applying a Fast Fourier Transform-based propagation operation to the scattering by the slices;
deriving high-angle scattering and back-scattering in the sample with respect to the scattering by the slices, through spatial position-based phase modulation in the spatial frequency domain or through frequency domain convolution of Green's function; and
calculating the multiple scattering in the sample by a combination of the scattering by the slices, the propagation among the slices, and the high-angle scattering and the back-scattering.

4. The method of claim 1, further comprising updating at least one parameter for the sample by an inverse algorithm for minimizing the difference between scattering measured with respect to the sample and the multiple scattering.

5. A computing device (100) comprising:
a memory; and
a processor connected to the memory and configured to execute at least one instruction stored in the memory,
wherein the processor is configured to detect scattering by each of a plurality of slices (21) obtained by dividing a sample (20) in an axial direction and to calculate multiple scattering in the sample, based on the scattering by the slices, wherein the processor is further configured to represent a spatially variable convolution associated with each slice by a Taylor expansion, to calculate the multiple scattering by combining the scattering by the slices, and to use the calculated multiple scattering to reconstruct a microstructure of the sample (20).

6. The computing device of claim 5, wherein the processor is configured to simulate the scattering by each of the slices by using at least one of the Born approximation, the Rytov approximation, Taylor expansion, or the pupil phase series.

7. The computing device of claim 5, wherein the processor is configured to derive the propagation among the slices by applying a Fast Fourier Transform-based propagation operation to the scattering by the slices, to derive high-angle scattering and back-scattering in the sample with respect to the scattering by the slices, through spatial position-based phase modulation in the spatial frequency domain or through frequency domain convolution of Green's function, and to calculate the multiple scattering in the sample by a combination of the scattering by the slices, the propagation among the slices, and the high-angle scattering and the back-scattering.

8. The computing device of claim 5, wherein the processor is configured to update at least one parameter for the sample by an inverse algorithm for minimizing the difference between scattering measured with respect to the sample and the multiple scattering.

9. A non-transitory computer-readable recording medium storing a computer program for executing a multiple scattering analysis method on a computing device,
the multiple scattering analysis method comprising:
detecting scattering by each of a plurality of slices obtained by dividing a sample in an axial direction; and
calculating multiple scattering in the sample, based on the scattering by the slices, wherein detecting scattering by each of the slices (21) comprises representing a spatially variable convolution associated with each slice by a Taylor expansion, wherein the multiple scattering is calculated by combining the scattering by the slices (21), and wherein the calculated multiple scattering is used to reconstruct a microstructure of the sample (20).

10. The recording medium of claim 9, wherein the multiple scattering analysis method further comprises updating at least one parameter for the sample by an inverse algorithm for minimizing the difference between scattering measured with respect to the sample and the multiple scattering.
